# EUROPÄISCHE PATENTSCHRIFT

(11) **EP 1 555 334 B1**
(45) Veröffentlichungstag und Bekanntmachung des Hinweises auf die Patenterteilung: **07.05.2008**
(21) Anmeldenummer: 04004928.0
(22) Anmeldetag: 03.03.2004
(51) Int. Cl.: C23C 14/24, C23C 14/28

(54) **Verdampfungseinrichtung für sublimierende Materialien**
Vaporization equipment for material sublimation
Installation de vaporisation pour la sublimation de matériaux

(30) Priorität: 14.01.2004 DE 102004001884
(43) Veröffentlichungstag der Anmeldung: 20.07.2005
(73) Patentinhaber: Applied Materials GmbH & Co. KG, 63755 Alzenau (DE)
(72) Erfinder: Klemm, Günter, 61667 Nidda (DE); Herzog, Jens, 63500 Seligenstadt (DE); Lotz, Hans-Georg, Dr., 63584 Gründau-Rothenbergen (DE)
(74) Vertreter: Schickedanz, Willi

(56) Entgegenhaltungen:
- EP-A- 0 477 474
- EP-A- 0 510 259
- US-A- 5 239 611
- PATENT ABSTRACTS OF JAPAN vol. 008, no. 134 (C-230), 21. Juni 1984 (1984-06-21) & JP 59 043872 A (KONISHIROKU SHASHIN KOGYO KK), 12. März 1984 (1984-03-12)

## Beschreibung

Die Erfindung bezieht sich auf eine Verdampfungseinrichtung für sublimierende Materialien gemäß dem Oberbegriff des Anspruchs 1.

Eine derartige Verdampfungseinrichtung ist in der US 5 239 611 beschrieben.

Eine Verdampfungseinrichtung ist auch in der GB 23 39 800 A beschrieben. Die Verdampfungseinrichtung wird z. B. in Vakuumbeschichtungsanlagen benötigt, um dünne Schichten eines bestimmten Materials, z. B. Zinksulfid, auf Folien aufzutragen. Eine solche Vakuumbeschichtungsanlage besteht aus einem evakuierbaren Rezipienten, in dem sich ein länglicher Schacht befindet, über den die zu beschichtende Folie bzw. Folienbahn mit Hilfe diverser Rollen geführt wird. In diesen Schacht wird die Verdampfungseinrichtung eingesetzt, so dass der aus der Verdampfungseinrichtung austretende Dampf sich in dünnen Schichten auf der Folie ablegen kann.

Die Verdampfungseinrichtung besteht im Wesentlichen aus langgestreckten Wannen zur Aufnahme des zu verdampfenden Materials und einer Heizeinrichtung. Die schon erwähnte GB 23 39 800 sieht insbesondere vor, dass die Heizeinrichtung aus Strahlungsheizern besteht, die unterhalb der Wanne angeordnet sind und den Boden der Wanne und damit indirekt das zu verdampfende Material erhitzen und somit zum Verdampfen bringen. Andere Vorrichtungen sehen Widerstandsheizungen vor, die in unmittelbarem Kontakt mit der Wanne stehen, so dass die Wärme durch Konvektion übertragen wird. Zum Stand der Technik sind auch zu nennen: EP 0 510 259, EP 0 477 474, sowie JP 59 043872.

Generell besteht das Problem, dass die Verdampfungseinrichtungen in der Lage sein müssen, relativ große Mengen von zu verdampfendem Material aufzunehmen, so dass die Beschichtungsanlagen möglichst lange ununterbrochen laufen können. Auf der anderen Seite sind regelmäßig Reinigungsarbeiten durchzuführen, da das zu verdampfende Material eben nicht nur zur Folie gelangt, sondern sich auch in anderen Bereichen der Verdampfungseinrichtung und der Beschichtungsvorrichtung ablegt. Die Verdampfungseinrichtung muss daher relativ leicht auseinandernehmbar sein und ebenso leicht nach der Reinigung wieder zusammengesetzt werden können. Außerdem muss über die Breite der Folie, also über die Länge der Verdampfungseinrichtung, eine möglichst gleichmäßige Dampfaustrittsrate vorliegen, so dass die Folie gleichmäßig beschichtet wird.

Die Strahlungsheizer gemäß der US 5 239 611 sind als stromdurchflossene Heizstäbe ausgebildet, die sich oberhalb der Wanne befinden, so dass die abgestrahlte Wärme unmittelbar auf das in der Wanne vorhandene, zu beschichtende Material gerichtet ist.

Auf diese Weise lässt sich zunächst eine große Gleichmäßigkeit der Wärmeeinstrahlung erzielen, da die Wärmeverteilung nicht durch Fluktuationen der Wärme innerhalb der Wanne beeinflusst werden kann. Des Weiteren werden gerade die oben in der Wanne liegenden Materialstücke aufgeheizt, so dass keine Wärmeverluste durch den Transport der Wärme durch den Boden und die unteren Schichten des in der Wanne vorhandenen Materials entstehen.

Um die Leistung der Verdampfungseinrichtung weiter zu verbessern, sieht die Erfindung vor, dass die Wanne durch einen Deckel geschlossen ist, der über einen Austrittsschlitz zum Austreten des Dampfes verfügt.

Da sich die Heizeinrichtungen oberhalb der Wanne, aber unterhalb des Deckels befinden, befinden sie sich innerhalb des von der Wanne und des Deckels gebildeten Gehäuses. Die Strahlungsleistung der Strahlungsheizer wirkt somit auch auf die Innenseite des Deckels, was verhindert, dass sich an dessen Wänden das Material wieder sublimieren kann.

Typischerweise sind die Wannen deutlich länger als breit, wobei in diesem Fall mehrere Heizstäbe quer zur Längsausdehnung der Wanne angeordnet sind.

Des Weiteren sind die Heizstäbe beidseitig in einem Tragring aus Hochtemperatur-Keramik gehalten. Dies erlaubt es, die Wanne und den Deckel selbst aus einem elektrisch leitenden und damit auch in der Regel gut wärmeleitenden Material, wie z. B. Molybdän, herzustellen, wodurch die Tragringe eine elektrische Isolierung des Heizstabes gegenüber dem Gehäuse ermöglichen.

Für eine einfache Montage werden die auf die Heizstäbe aufgesteckten Tragringe auf den Rand der Wannenöffnung aufgelegt. Der Deckel bzw. die Wanne besitzt an seinen bzw. ihren Außenwänden Ausschnitte, die den Tragrand umgreifen, so dass das Gehäuse bis auf den Austrittsschlitz zum Austreten des Dampfes vollständig geschlossen ist, was insbesondere bewirkt, dass der Dampf ausschließlich durch den Austrittsschlitz in Richtung auf die Folie geleitet wird. Auf diese Weise wird eine gute Ausbeute erreicht.

Die Heizstäbe sind etwas länger als die Wanne breit ist, so dass sie zu beiden Seiten der Wanne hervorstehen und von außen elektrisch kontaktiert werden können.

Dazu besitzt der Bedampfungsraum der Beschichtungsanlage seitliche Stempel mit elektrischen Kontakten, wobei zumindest die Stempel der einen Seite quer verfahrbar sind, so dass sie den Abstand von der Bedampfungsraumwand zur Verdampfungseinrichtung überbrücken können.

Im Folgenden soll anhand eines Ausführungsbeispiels die Erfindung näher erläutert werden. Dazu zeigen:
- Fig. 1: eine geöffnete Beschichtungsvorrichtung mit eingesetzter Verdampfungseinrichtung gemäß der Erfindung,
- Fig. 2: eine Verdampfungseinrichtung mit abgesetztem Deckel,
- Fig. 3: einen Querschnitt durch eine Beschichtungsanlage gemäß Figur 1.

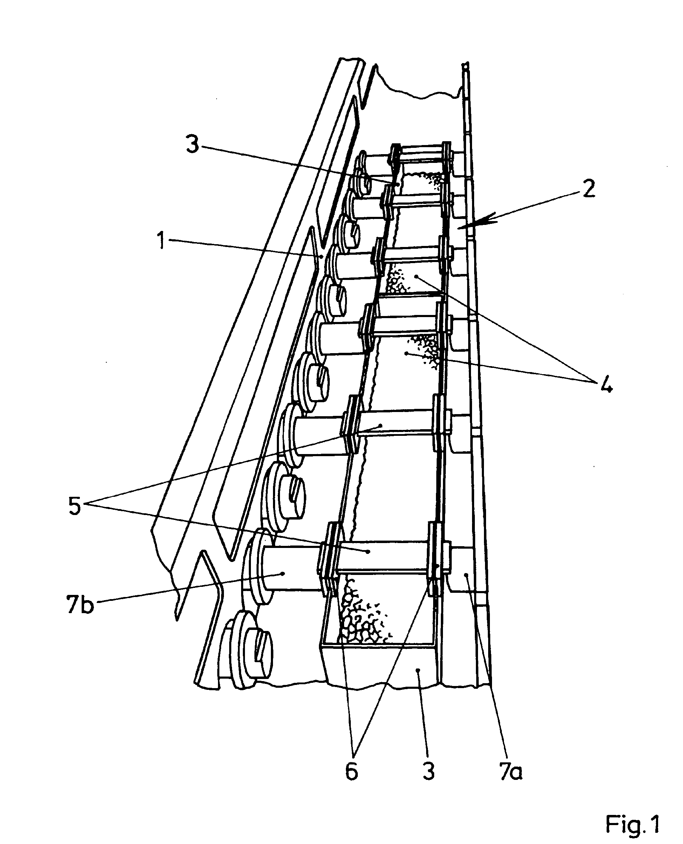

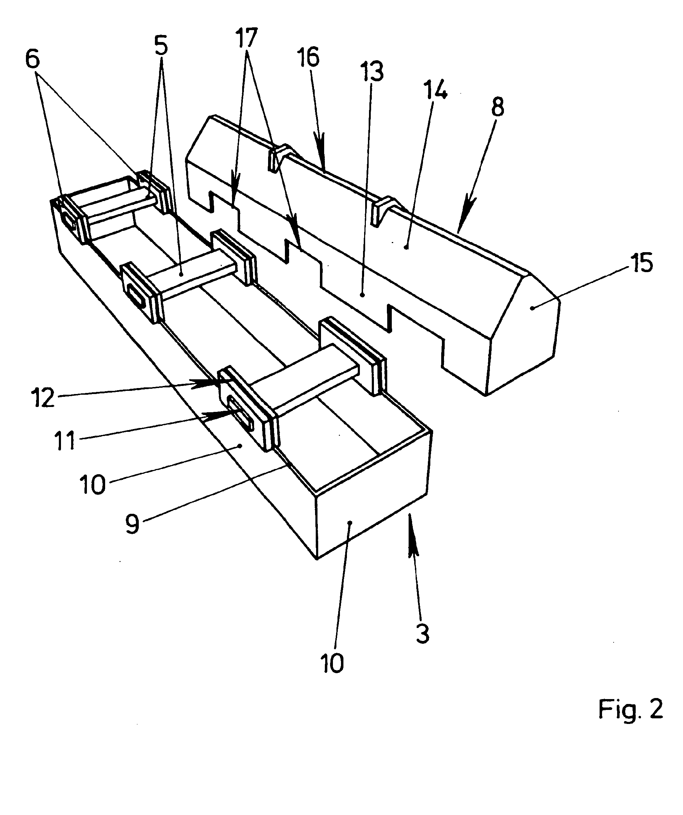

Zunächst wird auf die Figur 1 Bezug genommen. Man erkennt den Bedampfungsraum 1 einer Beschichtungsanlage, der sich schachtartig über die Breite der Anlage erstreckt. Mittels nicht gezeigter Rollen wird die zu beschichtende Folienbahn über die Bedampfungsraumöffnung geführt. In dem Bedampfungsraum 1 befindet sich eine Verdampfungseinrichtung 2, bestehend aus zwei länglichen Wannen 3, die mit ihren kurzen Seiten aneinander stoßen. In den Wannen 3 befindet sich das zu verdampfende Material 4, im vorliegenden Fall Zinksulfid-Granulat, die als Schüttgut in die Wanne eingebracht sind. Über jede Wanne 3 erstrecken sich drei Heizstäbe 5, die in gleichmäßigem Abstand zueinander angeordnet sind. Gehalten werden sie von Tragringen 6, wobei die Enden der Heizstäbe 5 seitlich über die Wanne 3 herausragen und mit aus den Bedampfungsraumwänden herausragenden Kontaktstempeln 7 kontaktiert werden können. Die Wannen 3 werden mittels Deckeln geschlossen, die in dieser Figur nicht gezeigt, aber in Figur 2 näher dargestellt sind: Diese zeigt eine Wanne 3, wobei zur besseren Verdeutlichung der zugehörige Deckel 8 seitlich abgesetzt ist.

Die Wanne 3 ist ein quaderförmiger Hohlkörper, dessen Oberseite vollständig offen ist, so dass ein rechteckig umlaufender Wannenrand 9 vorhanden ist, der von den Rändern der kurzen und langen Seitenwände 10 der Wanne 3 gebildet wird.

Wie schon erläutert, werden die Heizstäbe 5, die vorzugsweise aus Graphit bestehen, in Tragringen 6 gehalten. Diese sind rechteckig und weisen eine dem Querschnitt der Heizstäbe 5 angepasste innere Öffnung 11 auf, durch die das jeweilige Ende eines Heizstabes 5 hindurchgesteckt ist. Der Außenrand der Tragringe 6 ist mit einer umlaufenden Nut 12 versehen, die etwa so breit ist wie die Bleche dick sind, aus denen die Wanne 3 und der Deckel 8 hergestellt sind. Die Heizstäbe 5 werden auf die Wanne 3 aufgesetzt, wobei der Wannenrand 9 in die Nuten 12 der Tragringe 6 eingeführt wird.

Der neben der Wanne 3 gezeigte Deckel 8 hat die Form eines mit einem Giebeldach versehenen Hauses, hat also zwei rechteckige Seitenwände 13, zwei Dachschrägen 14 und zwei Giebelwände 15. Die Dachschrägen 14 laufen im First des Giebeldaches bis auf einen Schlitz zusammen, der als Austrittsschlitz 16 für den im Gehäuse erzeugten Dampf fungiert.

Die Seitenwände 13 des Deckels 8 sind in etwa so hoch wie die Tragringe 6 und verfügen über entsprechende rechteckige randoffene Ausschnitte 17 , die der Form der Tragringe 6 angepasst sind, so dass, wenn der Deckel aufgesetzt wird, der Rand der Ausschnitte 17 in die Nut 12 an den Tragringen 6 eintaucht. Bei aufgesetztem Deckel 8 ergibt sich somit ein geschlossenes Gehäuse, das quer von drei Heizstäben 5 durchsetzt ist und das an der Oberseite über einen Austrittsschlitz 16 für den Austritt des erzeugten Dampfes verfügt.

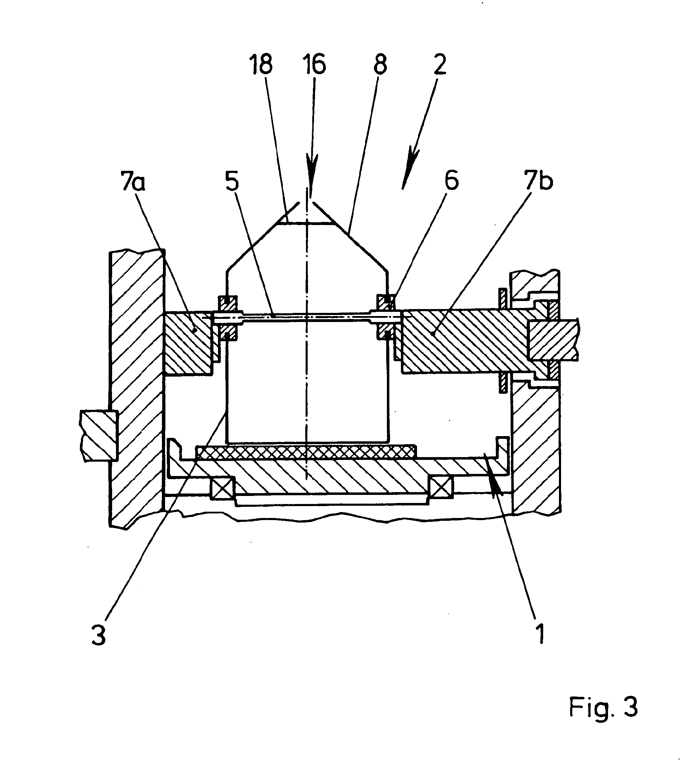

Um dies nochmals zu verdeutlichen, zeigt die Figur 3 einen Querschnitt durch die Verdampfungseinrichtung 2. Die Kontur des von einer Wanne 3 und einem Deckel 8 gebildeten Gehäuses entspricht im Querschnitt einem Rechteck, an dessen kurzer Seite ein Dreieck angesetzt ist. Im oberen Drittel des rechteckigen Gehäusebereiches wird das Gehäuse von den Heizstäben 5 durchzogen, die im Querschnitt rechteckig sind und mit ihren flachen Seite nach unten weisen. In der Figur 3 ist links ein feststehender Kontaktstempel 7a zum Kontaktieren des aus dem Gehäuse herausragenden einen Endes des Heizstabes 5 zu sehen. Auf der anderen Seite befindet sich ein verfahrbarer Kontaktstempel 7b, der sich an das andere Ende des aus dem Gehäuse herausragenden Heizstabes 5 anlegt. Über den Kontaktstempel wird der Heizstab 5 an eine Stromversorgung angeschlossen: Er heizt sich durch den hindurchfließenden Strom auf, wobei seine Wärmeenergie in Form von Strahlungsleistung insbesondere an das sich in der Wanne 3 befindende Material 4 abgegeben wird, das daraufhin verdampft.

Im Giebel des Deckels 8 befinden sich noch perforierte Abdeckbleche 18, die zwar einen Durchtritt des Dampfes erlauben, aber verhindern, dass Materialbrocken in den Bedampfungsraum 1 ausgetragen werden.

### Bezugszeichenliste

- 1: Bedampfungsraum
- 2: Verdampfungseinrichtung
- 3: Wannen
- 4: Material
- 5: Heizstab

- 6: Tragring
- 7: Kontaktstempel
- 8: Deckel
- 9: Rand
- 10: Seitenwand

- 11: innere Öffnung
- 12: Nut
- 13: Seitenwände
- 14: Dachschrägen
- 15: Giebelwände

- 16: Austrittsschlitz
- 17: randoffene Ausschnitte
- 18: Abdeckblech

## Patentansprüche

1. Verdampfungseinrichtung, insbesondere zum Einsatz in einer Vakuumbeschichtungsanlage für Folien mit wenigstens einer Wanne (3) zur Aufnahme des zu verdampfenden Materials (4) und einer aus Strahlungsheizern bestehenden Heizeinrichtung, wobei die Strahlungsheizer als stromdurchflossene Heizstäbe (5) ausgebildet sind, die sich oberhalb der Wanne (3) befinden, **dadurch gekennzeichnet, dass** sich auf der Wanne (3) ein Deckel (8) befindet, der mit einem Austrittsschlitz (16) für das verdampfte Material versehen ist, wobei der Heizstab (5) sich in dem von Deckel (8) und Wanne (3) gebildeten Gehäuse befindet, und dass sich im Giebel des Deckels (8) unterhalb des Austrittsschlitzes (16) perforierte Abdeckbleche 18 befinden, die zwar einen Durchtritt des Dampfes erlauben, aber verhindern, dass Materialbrocken in den Bedampfungsraum (1) ausgetragen werden.

2. Verdampfungseinrichtung nach Anspruch 1, **dadurch gekennzeichnet, dass** das Gehäuse länger als breit ist und dass in Längsrichtung jeweils mehrere, quer zur Längsausdehnung der Wanne (3) angeordnete Heizstäbe (5) vorhanden sind.

3. Verdampfungseinrichtung nach einem der vorhergehenden Ansprüche, **dadurch gekennzeichnet, dass** jeder Heizstab (5) beidseitig in jeweils einem Tragring (6) aus Hochtemperatur-Keramik gehalten ist.

4. Verdampfungseinrichtung nach Anspruch 3, **dadurch gekennzeichnet, dass** die Tragringe (6) auf dem Wannenrand (9) aufliegen und in entsprechende randoffene Ausschnitte (17) in den Deckel (8) oder die Wanne (3) hineinragen.

5. Verdampfungseinrichtung nach einem der vorhergehenden Ansprüche, **dadurch gekennzeichnet, dass** die Stirnseiten der Heizstäbe (5) seitlich aus dem Gehäuse hervorstehen.

6. Verdampfungseinrichtung nach einem der vorhergehenden Ansprüche, **dadurch gekennzeichnet, dass** die Heizstäbe (5) flach, vorzugsweise mit einem rechteckigen Querschnitt ausgebildet sind, wobei die flache Seite zur Wanne (3) gerichtet ist.

7. Verdampfungseinrichtung nach einem der vorhergehenden Ansprüche, **dadurch gekennzeichnet, dass** die Tragringe (6) mit einer umlaufenden Nut (12) versehen sind, in die die Ränder der Wanne (3) bzw. des Deckels (8) eintauchen.

## Claims

1. Vaporisation equipment, in particular for use in a vacuum coating system for films comprising at least one trough (3) for receiving the material (4) to be vaporised and a heating device consisting of radiant heaters, wherein the radiant heaters are formed as heating rods (5) through which current flows, which are located above the trough (3), **characterised in that** a lid (8) is located on the trough (3), said lid being provided with an outlet slit (16) for the vaporised material, wherein the heating rod (5) is located in the housing formed by the lid (8) and the trough (3), and that perforated cover sheets (18) are located in the gable of the lid (8) below the outlet slit (16), which allow the passage of vapour but prevent lumps of material from being removed into the vaporisation chamber (1).

2. The vaporisation equipment according to claim 1,
**characterised in that** the housing is longer than it is wide and that a plurality of heating rods (5) arranged transversely to the longitudinal extension of the trough (3) are provided in the longitudinal direction.

3. The vaporisation equipment according to any one of the preceding claims, **characterised in that** each heating rod (5) is held on both sides in respectively one supporting ring (6) made of high-temperature ceramic.

4. The vaporisation equipment according to claim 3,
**characterised in that** the supporting rings (6) lie on the trough edge (9) and project into corresponding open-edged sections (17) in the lid (8) or the trough (3).

5. The vaporisation equipment according to any one of the preceding claims, **characterised in that** the front faces of the heating rods (5) project laterally from the housing.

6. The vaporisation equipment according to any one of the preceding claims, **characterised in that** the heating rods (5) are configured as flat, preferably having a rectangular cross-section, wherein the flat side is directed towards the trough (3).

7. The vaporisation equipment according to any one of the preceding claims, **characterised in that** the supporting rings (6) are provided with a circumferential groove (12) into which the edges of the trough (3) or the lid (8) dip.

## Revendications

1. Dispositif d'évaporation, notamment destiné à l'utilisation dans un dispositif de revêtement de films sous vide, avec au moins une cuve (3) pour accueillir la matière à évaporer (4) et un dispositif de chauffage composé de dispositifs de chauffage radiants, les dispositifs de chauffage radiants étant conçus sous la forme de thermoplongeurs (5) traversés par du courant, se trouvant au dessus de la cuve (3) **caractérisé en ce que** sur la cuve (3) se trouve un couvercle (8) qui est muni d'une encoche de sortie (16) pour la matière évaporée, le thermoplongeur (5) se trouvant dans le boîtier formé par le couvercle (8) et la cuve (3) et **en ce que** dans la région du fronton du couvercle (8), en dessous de l'encoche de sortie (16) se trouvent des tôles de couverture (18) perforées, qui bien que permettant un passage de la vapeur, empêchent que des morceaux de la matière ne soient transportés dans la chambre de vaporisation (1).

2. Dispositif d'évaporation selon la revendication 1, **caractérisé en ce que** le boîtier est plus long que large et **en ce que** dans la direction longitudinale, il existe chaque fois plusieurs thermoplongeurs (5) disposés à la transversale de l'extension en longueur de la cuve (3).

3. Dispositif d'évaporation selon l'une quelconque des revendications précédentes, **caractérisé en ce que** chaque thermoplongeur (5) est maintenu sur les deux côtés par chaque fois une bague support (6) en céramique supportant la température d'ébullition.

4. Dispositif d'évaporation selon la revendication 3, **caractérisé en ce que** les bagues supports (6) reposent sur le bord de la cuve (9) et saillissent dans le couvercle (8) ou dans la cuve (3), dans des découpes (17) correspondantes, ouvertes sur les bords.

5. Dispositif d'évaporation selon l'une quelconque des revendications précédentes, **caractérisé en ce que** les faces frontales des thermoplongeurs (5) débordent latéralement du boîtier.

6. Dispositif d'évaporation selon l'une quelconque des revendications précédentes, **caractérisé en ce que** les thermoplongeurs (5) sont conçus sous forme plate, de préférence avec une section transversale rectangulaire, le côté plat étant dirigé vers la cuve (3).

7. Dispositif d'évaporation selon l'une quelconque des revendications précédentes, **caractérisé en ce que** les bagues supports (6) sont munies d'une rainure périphérique (12) dans laquelle plongent les bords de la cuve (3) ou du couvercle (8).
